# EUROPEAN PATENT APPLICATION

(11) **EP 4 210 444 A1**
(43) Date of publication of application: **12.07.2023**
(21) Application number: 21881784.9
(22) Date of filing: 15.09.2021
(51) Int. Cl.: H05K 7/20

(54) **DEVICE HEAT DISSIPATION METHOD AND HEAT DISSIPATION DEVICE**

(30) Priority: 23.10.2020 CN 202011148267
(71) Applicant: ZTE Corporation, Shenzhen, Guangdong 518057 (CN)
(72) Inventor: DUAN, Kaiwen, Shenzhen, Guangdong 518057 (CN); LI, Shuai, Shenzhen, Guangdong 518057 (CN); LIU, Xin, Shenzhen, Guangdong 518057 (CN); LIU, Fan, Shenzhen, Guangdong 518057 (CN); WANG, Yan, Shenzhen, Guangdong 518057 (CN)
(74) Representative: Savi, Massimiliano
(86) International application number: PCT/CN2021/118579
(87) International publication number: WO 2022/083365

(57) **Abstract**

A device heat dissipation method and a heat dissipation device. The heat dissipation device comprises a housing (1), a heating device (2), a heat sink substrate (3), and a heat dissipation component (4). The heating device (2) is provided inside the housing (1). The heat sink substrate (3) is fixedly connected to the housing (1). The heat dissipation component (4) is fixedly connected to the heat sink substrate (3). The heat dissipation component (4) simultaneously covers a near heat source area and a remote heat source area. The heat dissipation component (4) is configured to absorb heat generated by the heating device (2). Part of the heat is transferred from the near heat source area to the remote heat source area, and enhanced heat dissipation is carried out by using the air of the remote heat source area.

## Description

### CROSS-REFERENCE TO RELATED APPLICATION

This application is based on and claims the priority of Chinese patent application No. 202011148267.7 filed on October 23, 2020, the disclosure of which is incorporated herein by reference in its entirety.

### TECHNICAL FIELD

Embodiments of the present disclosure relate to the field of heat dissipation, and in particular to a method for dissipating heat from a device and a heat dissipation device.

### BACKGROUND

With the rapid development of power electronics technology, electronic devices are increasingly developing in the direction of large capacity, high power, high integration and light weight, thereby leading to an increasing heat consumption density of the device system and increasing requirements for environmental adaptability. The high-reliability heat dissipation of the electronic devices has gradually become a bottleneck that limits the development of related industries.

Communication base station devices based on AAU and RRU have high reliability requirements, and their application scenarios require to be maintenance-free, such that cooling is usually done by natural heat dissipation. However, due to the limitation of heat dissipation technology and heat dissipation means, the commonly used natural heat dissipation methods cannot meet the increasing heat consumption requirements of the communication base station devices.

The natural heat dissipation method for traditional communication base station devices mainly includes two aspects: conducting heat from a heat release element stage by stage to a heat sink outside a device housing, and keeping the temperature as uniform as possible during this process (a heat conduction and diffusion process); and dissipating the heat conducted to the heat sink into the air through natural convection and radiation heat exchange (a heat dissipation process). In the whole heat transfer path, the thermal resistance of diffusion and the thermal resistance of conduction only account for about 30%, while the thermal resistance of convection heat exchange accounts for as much as 70%.

In view of the existing disclosed natural heat dissipation methods for the communication base station devices, on the one hand, the thermal resistance of conduction in the heat transfer path is reduced by utilizing a high heat conduction interface material, etc., and on the other hand, the thermal resistance of diffusion in the heat transfer path is reduced by the temperature uniformity characteristics of a two-phase heat transfer apparatus such as a uniform temperature chamber, a heat pipe, and PCI fins. The above two technologies only optimize the thermal resistances which account for 30%.

At present, in various industrial application scenarios, the structural form of PCI fins is mainly rectangular flat metal fins with pipelines. The research status of PCI fins in the industry is as follows. In one aspect, attention is paid to the form of their internal pipelines, such as honeycomb pipelines, Brachistochrone curve pipelines and partitioned pipelines, such that the two-phase flow pattern of an internal working medium is changed through the optimization of the form of the pipelines, so as to improve the temperature uniformity of PCI fins, that is, to reduce the thermal resistance of diffusion of the two-phase apparatus. In another aspect, attention is paid to the processing technology of PCI fins and the connection with a heat sink substrate, such as single-sided inflation technology, double-sided inflation technology, tooth inserting technology, and tooth bonding technology.

In the product structure schemes for the communication base stations disclosed in some situations in the art, the traditional straight-tooth heat sink is improved into a V-tooth heat sink to reduce the thermal resistance of convection heat exchange of the system and improve the heat dissipation efficiency of the system. The V-tooth structure strengthens the vertical air intake of the heat sink and increases the heat dissipation area; and a side air outlet is added, which shortens the airflow heat dissipation path and improves the thermal cascade problem. Under the condition of the same tooth height, the temperature of the key apparatus of the V-tooth system is 1-3°C lower than that of the straight-tooth system. Although the V-tooth heat sink scheme brings some advantages for lowering the temperature, it increases the process complexity in fin production and connection, resulting in an increase in cost. Moreover, the straight-tooth and V-tooth heat sink schemes both only use the airflow in a near heat source area to cool the system, such that the structure of the system has a great resistance to the heat dissipation airflow, and the airflow temperature is relatively high, resulting in low natural convection heat exchange efficiency.

The existing natural heat dissipation methods may only solve the problem of continuous increase in system heat consumption by continuously increasing the tooth height. However, the increase of tooth height not only leads to the decrease of the fin efficiency of heat dissipation teeth, but also significantly increases the total volume of the system and reduces the market competitiveness of products.

In view of the problem in some situations in the art that the continuous increase of system heat dissipation may only be solved by continuously increasing the tooth height, resulting in low fin efficiency of the heat dissipation teeth, and the low volumetric heat dissipation density and weight heat dissipation density of the system, there is still a desire for solutions.

### SUMMARY

Embodiments of the present disclosure provide a method for dissipating heat from a device and a heat dissipation device, which at least to a certain extent solves the problem in some situations in the art that the continuous increase of system heat dissipation may only be solved by continuously increasing the tooth height, resulting in low fin efficiency of the heat dissipation teeth, and the low volumetric heat dissipation density and weight heat dissipation density of the system.

According to an embodiment of the present disclosure, there is provided a heat dissipation device, including: a housing 1, a heat release apparatus 2, a heat sink substrate 3 and a heat dissipation component 4, where the heat release apparatus 2 is arranged inside the housing 1, the heat sink substrate 3 is fixedly connected to the housing 1, the heat dissipation component 4 is fixedly connected to the heat sink substrate 3, and the heat dissipation component 4 covers both a near heat source area and a far heat source area; and the heat dissipation component 4 is configured to absorb heat generated by the heat release apparatus 2 and transfer part of the heat from the near heat source area to the far heat source area, so as to enhance heat dissipation by utilizing air in the far heat source area.

According to another embodiment of the present disclosure, there is also provided a method for dissipating heat from a device. The method includes: absorbing, by a heat dissipation component 4, heat generated by a heat release apparatus 2, where the device includes a housing 1, the heat release apparatus 2, a heat sink substrate 3 and the heat dissipation component 4, where the heat release apparatus 2 is arranged inside the housing 1, the heat sink substrate 3 is fixedly connected to the housing 1, the heat dissipation component 4 is fixedly connected to the heat sink substrate 3, and the heat dissipation component 4 covers both a near heat source area and a far heat source area; and transferring part of the heat from the near heat source area to the far heat source area, so as to enhance heat dissipation by utilizing air in the far heat source area.

### BRIEF DESCRIPTION OF DRAWINGS

Fig. 1 is a schematic diagram of a configuration of a heat dissipation device according to an embodiment of the present disclosure;
Fig. 2 is a flowchart of a method for dissipating heat from a device according to an embodiment of the present disclosure;
Fig. 3 is a schematic diagram of a heat dissipation device according to an embodiment of the present disclosure;
Fig. 4 is a schematic diagram of the division of heat dissipation areas according to an embodiment of the present disclosure;
Fig. 5 is a schematic diagram of a heat dissipation tooth according to an embodiment of the present disclosure;
Fig. 6 is a schematic diagram illustrating related dimensions of a heat dissipation tooth according to an embodiment of the present disclosure;
Fig. 7 is a schematic diagram of a tubular flow channel-type inner cavity according to an embodiment of the present disclosure;
Fig. 8 is a schematic diagram of a configuration of a flow guide plate according to an embodiment of the present disclosure;
Fig. 9 is a schematic diagram of a configuration of a bent auxiliary tooth according to an embodiment of the present disclosure;
Fig. 10 is a schematic diagram of a configuration of a V-shaped auxiliary tooth according to an embodiment of the present disclosure; and
Fig. 11 is a schematic diagram of a two-phase principle of a heat dissipation method according to an embodiment of the present disclosure.

### DETAILED DESCRIPTION

The embodiments of the present disclosure will be described in detail below with reference to the accompanying drawings in conjunction with embodiments.

It should be noted that the terms "first", "second", etc. in the description and the claims of the present disclosure and the above-mentioned drawings are intended to distinguish similar objects and are not necessarily to describe a specific order or sequence.

Embodiments of the present disclosure provide a method for dissipating heat from a device and a heat dissipation device, which at least to a certain extent solves the problem in some situations in the art that the continuous increase of system heat dissipation may only be solved by continuously increasing the tooth height, resulting in low fin efficiency of the heat dissipation teeth, and the low volumetric heat dissipation density and weight heat dissipation density of the system.

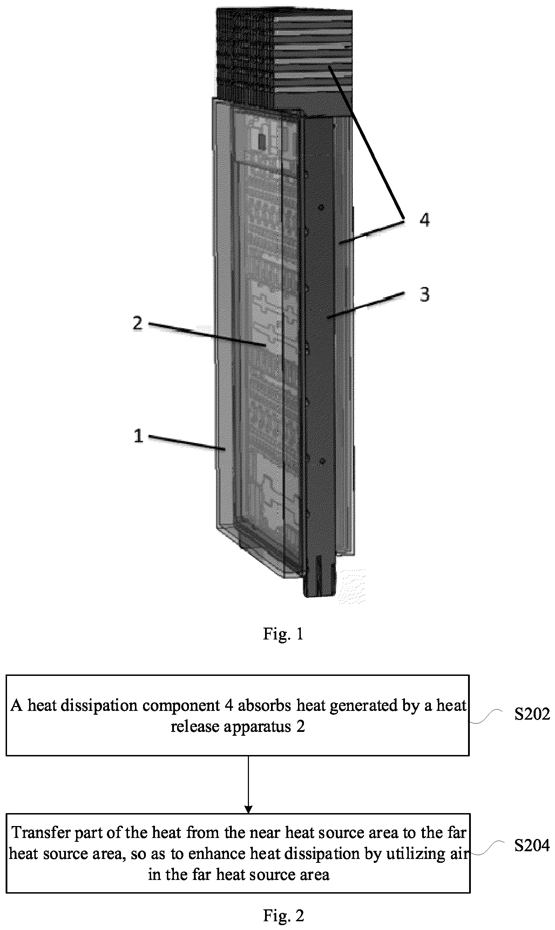

According to an embodiment of the present disclosure, there is provided a heat dissipation device. Fig. 1 is a schematic diagram of a configuration of a heat dissipation device according to an embodiment of the present disclosure. As shown in Fig. 1, the heat dissipation device includes: a housing 1, a heat release apparatus 2, a heat sink substrate 3 and a heat dissipation component 4. The heat release apparatus 2 is arranged inside the housing 1, the heat sink substrate 3 is fixedly connected to the housing 1, the heat dissipation component 4 is fixedly connected to the heat sink substrate 3, and the heat dissipation component 4 covers both a near heat source area and a far heat source area. The heat dissipation component 4 is configured to absorb heat generated by the heat release apparatus 2 and transfer part of the heat from the near heat source area to the far heat source area, so as to enhance heat dissipation by utilizing air in the far heat source area. That is, most of the heat is transferred from the near heat source area to the far heat source area, so as to enhance heat dissipation by utilizing sufficient and low-temperature air in the far heat source area.

In an embodiment, the heat dissipation component 4 includes a plurality of heat dissipation teeth 40 arranged in parallel to and spaced apart from each other. Each of the heat dissipation teeth 40 includes a straight tooth 41, an extensional tooth 42, an inner cavity 43, and a heat transfer working medium 44. The straight tooth 41 and the extensional tooth 42 are of an integrated structure. The configuration of the extensional tooth 42 is not limited. The straight tooth 41 is arranged within the range of a substrate outer edge of the heat sink substrate 3. The extensional tooth 42 partially or completely extends beyond the range of the substrate outer edge of the heat sink substrate 3. The straight tooth 41 is located in the near heat source area, the extensional tooth 42 is located in the far heat source area, and the inner cavity 43 is filled with the heat transfer working medium 44. A pool boiling state is created in the inner cavity 43 by the heat transfer working medium 44 absorbing heat and the heat is transferred to the far heat source area through vaporization.

In an embodiment, the straight tooth 41 has a length less than or equal to a longitudinal outer edge dimension of the housing 1, and the extensional tooth 42 has a length that is equal to the length of the straight tooth 41 multiplied by a preset number.

In an embodiment, the inner cavity 43 is of an integral continuous structure, and the inner cavity 43 occupies the straight tooth 41 and the extensional tooth 42.

In an embodiment, the inner cavity 43 is of a hollow cavity structure or a tubular flow channel structure.

In an embodiment, an upper inner cavity in the extensional tooth 42 is configured to be of an inclined structure and transitions to and communicates with a lower inner cavity in the straight tooth 41.

In an embodiment, the heat transfer working medium 44 has a liquid level higher than a main heat release element and a heat sensitive element of the heat release apparatus 2.

In an embodiment, an array of reinforcing ribs is formed inside the inner cavity 43 by means of local pressing, support columns or the like, to increase a structural strength of the heat dissipation teeth 40. The reinforcing rib includes but is not limited to one of: a honeycomb structure, a circle structure, a triangle structure, or a square structure.

In an embodiment, the heat dissipation device further includes a flow guide plate 5. The flow guide plate 5 is fixedly connected to the heat dissipation component 4 in a snap-fit manner, and the flow guide plate 5 is arranged in a boundary area between the straight tooth 41 and the extensional tooth 42.

In an embodiment, an auxiliary heat dissipation component 6 is fixedly provided on the extensional tooth 42. The auxiliary heat dissipation component 6 includes but is not limited to a V-tooth or straight-tooth structure, or the auxiliary heat dissipation component 6 is formed by bending the extensional tooth 42.

Based on the heat dissipation device described above, provided in this embodiment is a method for dissipating heat from a device. Fig. 2 is a flowchart of a method for dissipating heat from a device according to an embodiment of the present disclosure. As shown in Fig. 2, the process includes the following steps.

At step S202, heat generated by a heat release apparatus 2 is absorbed by a heat dissipation component 4. The device includes a housing 1, the heat release apparatus 2, a heat sink substrate 3 and the heat dissipation component 4. The heat release apparatus 2 is arranged inside the housing 1, the heat sink substrate 3 is fixedly connected to the housing 1, the heat dissipation component 4 is fixedly connected to the heat sink substrate 3, and the heat dissipation component 4 covers both a near heat source area and a far heat source area.

In an embodiment, step S202 described above may include: absorbing, by a heat transfer working medium 44 of the heat dissipation component 4, the heat generated by the heat release apparatus 2. The heat dissipation component 4 is composed of a plurality of heat dissipation teeth 40 arranged in parallel to and spaced apart from each other. Each of the heat dissipation teeth 40 includes a straight tooth 41, an extensional tooth 42, an inner cavity 43, and a heat transfer working medium 44. The straight tooth 41 and the extensional tooth 42 are of an integrated structure. The configuration of the extensional tooth 42 is not limited. The straight tooth 41 is arranged within the range of a substrate outer edge of the heat sink substrate 3. The extensional tooth 42 partially or completely extends beyond the range of the substrate outer edge of the heat sink substrate 3. The straight tooth 41 is located in the near heat source area, the extensional tooth 42 is located in the far heat source area, and the inner cavity 43 is filled with the heat transfer working medium 44. A main evaporation area of the heat dissipation tooth 40 is located in a lower inner cavity in the straight tooth 41, and a main condensation area of the heat dissipation tooth 40 is located in an upper inner cavity in the extensional tooth 42.

At step S204, part of the heat is transferred from the near heat source area to the far heat source area, so as to enhance heat dissipation by utilizing air in the far heat source area.

In an embodiment, step S204 described above may include: creating a pool boiling state in the inner cavity 43 by the heat transfer working medium 44 absorbing heat and transferring part of the heat to the far heat source area through vaporization. While sucking in air from the near heat source area to dissipate heat, the heat dissipation device also sucks in air from the far heat source area to enhance the heat dissipation, and quickly dissipates the heat transferred to the far heat source area.

Through steps S202 to S204 described above, the problem in some situations in the art that the continuous increase of system heat dissipation may only be solved by continuously increasing the tooth height, resulting in low fin efficiency of the heat dissipation teeth, and the low volumetric heat dissipation density and weight heat dissipation density of the system can be solved, such that the heat dissipation component gets rid of the constraints of pipelines and the form of the pipelines, and the long-distance high-efficiency natural heat dissipation of the device is realized under the structural support of the heat dissipation component.

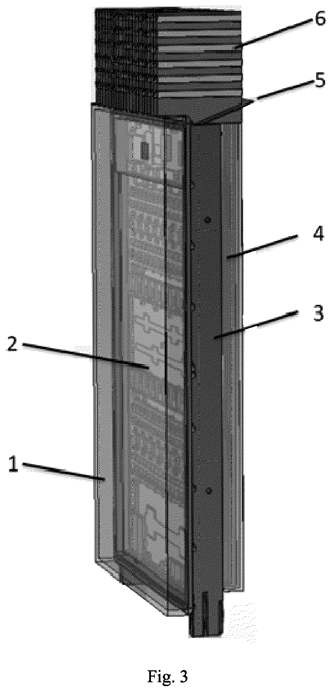

The heat dissipation device of the embodiments of the present disclosure may be an AAU/RRU, which is mainly applied to the natural heat dissipation of a communication base station device with high heat consumption, and is suitable for application scenarios where natural air is used to dissipate heat from and cool the device. Fig. 3 is a schematic diagram of a heat dissipation device according to an embodiment of the present disclosure. As shown in Fig. 3, the heat dissipation device includes an AAU/RRU housing 1, a heat release apparatus 2, a heat sink substrate 3, a heat dissipation component 4, a flow guide plate 5, and auxiliary teeth 6. The heat dissipation component 4 includes a plurality of heat dissipation teeth 40. The plurality of heat dissipation teeth 40 may be arranged in parallel to and spaced apart from each other, and the spacings between each two heat dissipation teeth may be the same or different.

The heat release apparatus 2 is typically attached to the inside of the AAU/RRU housing 1 by utilizing a heat conductive adhesive or a heat conductive medium, and the side on which the heat release apparatus 2 is arranged is referred to as a heat source side.

The heat sink substrate 3 is typically attached to an outer surface near the heat source side of the AAU/RRU housing 1, or is directly cast as a whole with the AAU/RRU housing 1.

The heat dissipation teeth 40 are connected and fixed to the heat sink substrate 3 by means of tooth inserting, bonding, etc., to form a high-efficiency heat dissipation structure together with the substrate. Optionally, the heat dissipation teeth may be placed vertically or inclined at a certain angle with the horizontal direction.

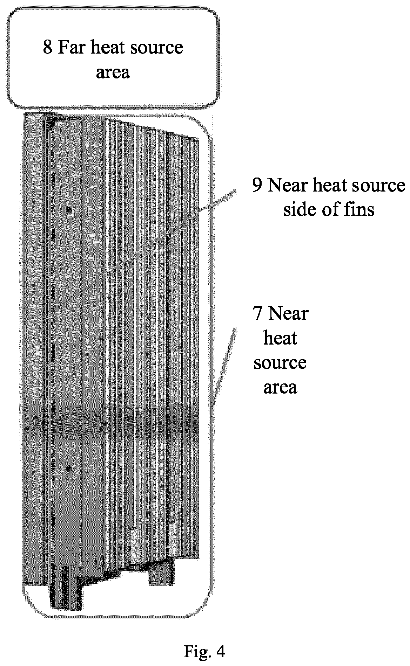

Fig. 4 is a schematic diagram of the division of heat dissipation areas of a heat dissipation device according to an embodiment of the present disclosure. As shown in Fig. 4, the main heat dissipation space may be divided into two parts according to the relative position with respect to the device: a near heat source area 7 and a far heat source area 8.

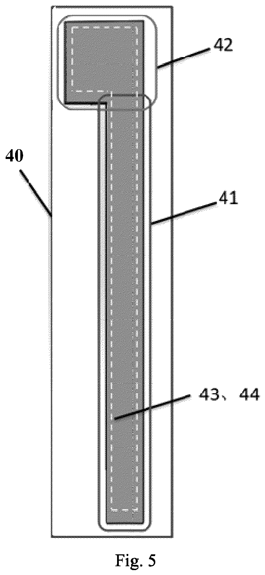

Fig. 5 is a schematic diagram of a heat dissipation tooth of a heat dissipation device according to an embodiment of the present disclosure. As shown in Fig. 5, the heat dissipation tooth 40 is an integral heat dissipation fin, which is typically made of metal, such as aluminum and copper. The heat dissipation tooth 40 is composed of a lower straight tooth portion (i.e., straight tooth 41) in the near heat source area, an upper extensional tooth portion (i.e., extensional tooth 42) in the far heat source area, an inner cavity 43, and a heat transfer working medium 44. The straight tooth 41 in the near heat source area is close to the heat release apparatus 2, the structure and shape thereof are not limited, and is mostly of a rectangular flat plate type.

The straight tooth 41 has a length typically less than or equal to a longitudinal outer edge dimension of the AAU/RRU housing 1. Advantageously, the straight tooth 41 has a height between 30 mm and 110 mm.

The extensional tooth 42 in the far heat source area is not constrained in the structure and shape, and is advantageously the rectangular flat plate type (the form adopted in this embodiment).

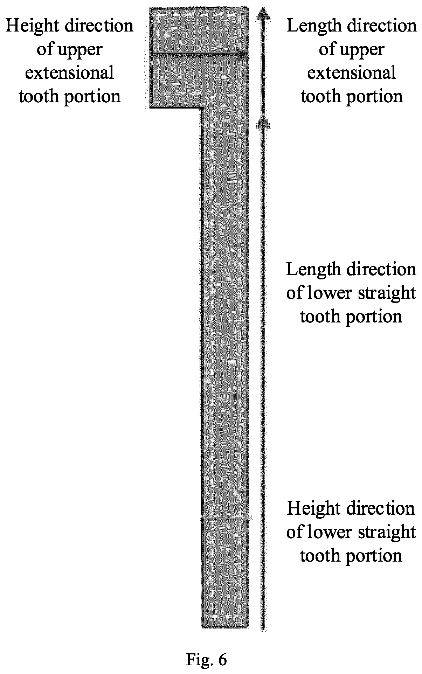

Fig. 6 is a schematic diagram illustrating dimensions of a heat dissipation tooth according to an embodiment of the present disclosure. As shown in Fig. 6, advantageously, the length of the extensional tooth 42 is 0.1 to 0.4 times the length of the lower straight tooth portion; and the height of the extensional tooth 42 is as great as possible, until it is flush with a transverse outer edge of the AAU/RRU housing 1.

The inner cavity 43 is formed inside the heat dissipation tooth 40 by a mold processing, an inflation process, or the like, and the structural form of the inner cavity is not limited, which may be a hollow cavity structure or a tubular flow channel structure.

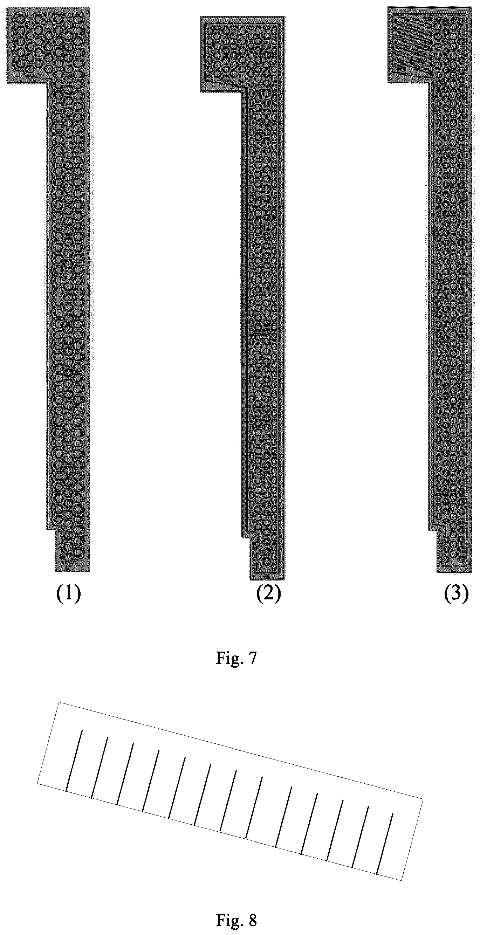

Fig. 7 is a schematic diagram of a tubular flow channel-type inner cavity according to an embodiment of the present disclosure. As shown in Fig. 7, when the inner cavity 43 is of a tubular flow channel structure, the design of the flow channel is not limited. An upper pipeline of the inner cavity transitions to and communicates with a lower pipeline of the inner cavity via an inclined structure design, so as to help condensate from the upper portion of the inner cavity quickly flow back and supplement to the lower portion of the inner cavity.

The inner cavity 43 is of a continuous integral structure, and occupies both the straight tooth 41 and the extensional tooth 42.

In order to ensure that the coverage of the inner cavity 43 is as large as possible and meets the processing requirements, taking Fig. 7 as an example, advantageously, the limit dimensions of the left and right sides of the inner cavity 43 are 2-6 mm from the left and right outer edge dimensions of the heat dissipation tooth 40, and the limit dimensions of the upper and lower sides of the inner cavity 43 are 6-12 mm from the upper and lower outer edge dimensions of the heat dissipation tooth 40.

An array of reinforcing ribs is formed inside the inner cavity 43 by means of local pressing, by means of support columns or the like, to increase a structural strength of the heat dissipation teeth 40. The reinforcing rib includes but is not limited to one of: a honeycomb structure, a circle structure, a triangle structure, or a square structure.

After vacuuming, the inner cavity 43 is filled with the heat transfer working medium 44. The filling liquid level should be higher than a main heat release element and a heat sensitive element in the heat release apparatus 2. After filling, the end of a filling port is sealed by mechanical or welding means.

Fig. 8 is a schematic diagram of a configuration of a flow guide plate according to an embodiment of the present disclosure. As shown in Fig. 8, the flow guide plate 5 is fixed to the heat dissipation tooth 40 in a snap-fit manner, and the height of the flow guide plate is located near a boundary area between the straight tooth 41 and the extensional tooth 42.

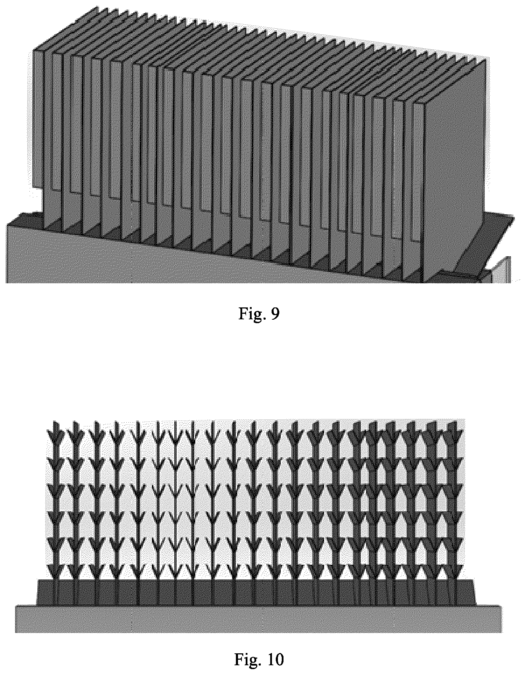

The auxiliary heat dissipation component is typically an auxiliary tooth, which may be a separate metal fin having a configuration not limited herein, and is connected and fixed to the extensional tooth 42 by welding or the like. Fig. 9 is a schematic diagram of a configuration of a bent auxiliary tooth according to an embodiment of the present disclosure. The bent auxiliary tooth may be formed directly by lateral bending of the extensional tooth 42. Fig. 10 is a schematic diagram of a configuration of a V-shaped auxiliary tooth according to an embodiment of the present disclosure. The V-shaped auxiliary tooth is connected and fixed to the extensional tooth 42 by welding or other means.

In an embodiment of the present disclosure, the structural forms of the heat dissipation tooth 40 and the inner cavity 43 are not constrained, but the heat dissipation tooth 40 and the inner cavity 43 both have structural characteristics extending from the near heat source area to the far heat source area. Benefiting from the toothed structure characteristics of the heat dissipation tooth 40, the heat dissipation tooth 40 may form distinct evaporation and condensation areas. The main evaporation area is located in the lower inner cavity in the straight tooth 41, and the main condensation area is located in the upper inner cavity in the extensional tooth 42.

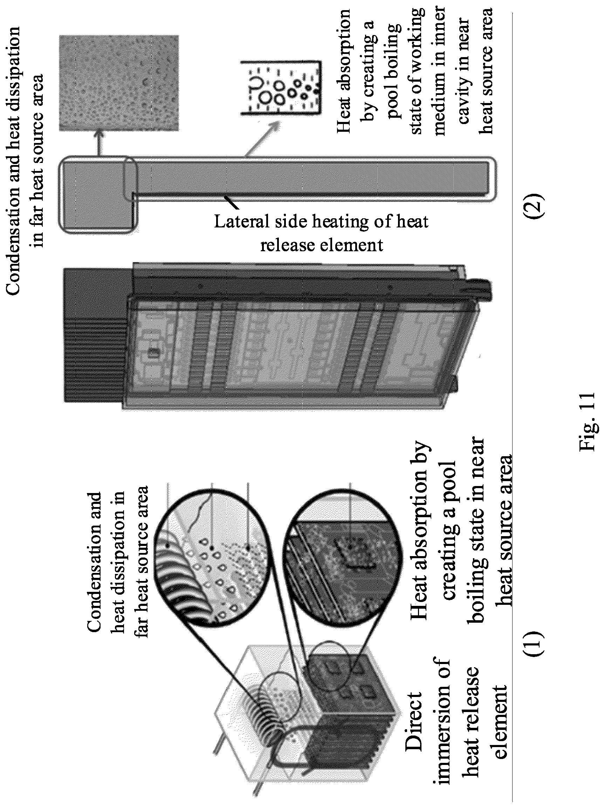

Fig. 11 is a schematic diagram of the two-phase principle of a heat dissipation method according to an embodiment of the present disclosure. Under the support of the tooth shape and the inner cavity structure, the heat dissipation tooth 40 realizes the long-distance high-efficiency natural heat dissipation as shown in Fig. 11, which may be equivalent to the immersion liquid cooling effect. The liquid working medium in the lower portion of the inner cavity continuously absorbs heat from the near heat source side of a fin and is vaporized to form a stable pool boiling state, while the gaseous working medium carries a large amount of latent heat and is rapidly transferred to the upper portion of the inner cavity for condensation and heat dissipation, thus realizing rapid heat transfer and high-efficiency heat dissipation from the near heat source area to the far heat source area.

Because of the liquid filling characteristics of the liquid level in the cavity higher than the main heat release apparatus, this heat dissipation method ensures that the space on the near heat source side of the inner cavity is continuously soaked with enough liquid working fluid to avoid dry burning, and reduces the overheat risk of the apparatus at the corresponding position.

While sucking in air from the near heat source area to dissipate heat, the system may also suck in air from the far heat source area to dissipate heat, so as to achieve an enhanced heat dissipation effect. Because of the extensional characteristics of the toothed structure, the upper portion of the inner cavity is located in the far heat source area, the inside thereof is filled with the high-temperature gaseous working medium, and the outside thereof is surrounded by sufficient low-temperature air. The flow channel formed between the heat dissipation teeth is unobstructed in the front and rear direction, has a low airflow resistance, and can suck in air from the back side of the heat sink to increase the flow rate of the airflow. Under the condition of large temperature difference and high flow rate, strong natural convection can be formed on the surface of the extensional portion of the heat dissipation tooth, such that the gaseous working medium in the upper portion of the inner cavity rapidly dissipates heat and is condensed, and continuously replenishes liquid for the lower portion of the inner cavity, thereby enhancing the two-phase heat exchange degree, maintaining the two-phase circulation, and ensuring stable and continuous heat transfer and temperature uniformity of the heat dissipation tooth.

On the basis of the above, the heat dissipation performance of the extensional tooth portion can be further enhanced by introducing the flow guide plate and adding the auxiliary heat dissipation component (auxiliary tooth or bent teeth).

According to the method for dissipating heat from a device of the embodiments of the present disclosure, the problem in some situations in the art that the continuous increase of system heat dissipation may only be solved by continuously increasing the tooth height, resulting in low fin efficiency of the heat dissipation teeth, and the low volumetric heat dissipation density and weight heat dissipation density of the system can be solved, and the problems of non-obvious two-phase partition of the traditional PCI fins, insufficient liquid replenishment of a near heat source side pipeline, the pipeline only covering the near heat source area, and the complex connection process of fin teeth of the V-tooth heat sink can also be solved, such that the heat dissipation component 4 is free of the constraints of pipelines and the form of the pipelines, and the long-distance high-efficiency natural heat dissipation of the device is realized under the structural support of the heat dissipation component 4.

The method for dissipating heat from a device of the embodiments of the present disclosure solves the problems in the original PCI fin technology of the non-obvious two-phase partition of the heat dissipation fins, insufficient liquid replenishment of a near heat source side pipeline, and the pipeline only covering the near heat source area; avoids the complication of the machining and connection processes of the heat dissipation teeth of the V-tooth heat sink; reduces the height of the heat dissipation teeth and improves the fin efficiency of the heat dissipation teeth; and increases the system volumetric heat dissipation density by more than 10% and the weight heat dissipation density by 5%.

The above is only the description of some embodiments of the present disclosure, and is not intended to limit the present disclosure. It will be apparent to those having ordinary skill in the art that various modifications and variations can be made to the present disclosure. Any modifications, equivalent substitutions, improvements, etc. made within the principle of the present disclosure shall fall within the scope of protection of the present disclosure.

## Claims

1. A heat dissipation device, comprising: a housing (1), a heat release apparatus (2), a heat sink substrate (3) and a heat dissipation component (4), wherein
the heat release apparatus (2) is arranged inside the housing (1), the heat sink substrate (3) is fixedly connected to the housing (1), the heat dissipation component (4) is fixedly connected to the heat sink substrate (3), and the heat dissipation component (4) covers both a near heat source area and a far heat source area; and
the heat dissipation component (4) is configured to absorb heat generated by the heat release apparatus (2) and transfer part of the heat from the near heat source area to the far heat source area, so as to enhance heat dissipation by utilizing air in the far heat source area.

2. The heat dissipation device of claim 1, wherein
the heat dissipation component (4) comprises a plurality of heat dissipation teeth (40) arranged in parallel to and spaced apart from each other;
each of the heat dissipation teeth (40) comprises a straight tooth (41), an extensional tooth (42), an inner cavity (43), and a heat transfer working medium (44), wherein the extensional tooth (42) extends beyond a substrate outer edge of the heat sink substrate (3), the straight tooth (41) is located in the near heat source area, the extensional tooth (42) is located in the far heat source area, and the inner cavity (43) is filled with the heat transfer working medium (44); and
the heat transfer working medium (44) is configured to absorb the heat generated by the heat release apparatus (2), create a pool boiling state in the inner cavity (43), and transfer the heat to the far heat source area through vaporization.

3. The heat dissipation device of claim 2, wherein
the straight tooth (41) has a length less than or equal to a longitudinal outer edge dimension of the housing (1), the extensional tooth (42) has a length which is equal to the length of the straight tooth (41) multiplied by a preset number, the extensional tooth (42) and the straight tooth (41) are of an integrated structure, the straight tooth (41) is arranged within the range of the substrate outer edge of the heat sink substrate (3), and the extensional tooth (42) partially or completely extends beyond the range of the substrate outer edge of the heat sink substrate (3).

4. The heat dissipation device of claim 2, wherein
the inner cavity (43) is of an integral continuous structure, and the inner cavity (43) occupies the straight tooth (41) and the extensional tooth (42).

5. The heat dissipation device of claim 2, wherein the inner cavity (43) is of a hollow cavity structure or a tubular flow channel structure.

6. The heat dissipation device of claim 2, wherein an upper inner cavity in the extensional tooth (42) is configured to be of an inclined structure and transitions to and communicates with a lower inner cavity in the straight tooth (41).

7. The heat dissipation device of claim 2, wherein the heat transfer working medium (44) has a liquid level higher than a main heat release element and a heat sensitive element of the heat release apparatus (2).

8. The heat dissipation device of claim 2, wherein
an array of reinforcing ribs is formed inside the inner cavity (43) by means of local pressing or by means of support columns, to increase a structural strength of the heat dissipation teeth (40), wherein the reinforcing rib comprises one of: a honeycomb structure, a circle structure, a triangle structure, or a square structure.

9. The heat dissipation device of claim 2, further comprising a flow guide plate (5), wherein the flow guide plate (5) is fixedly connected to the heat dissipation component (4) in a snap-fit manner, and the flow guide plate (5) is arranged in a boundary area between the straight tooth (41) and the extensional tooth (42).

10. The heat dissipation device of claim 2, wherein an auxiliary heat dissipation component (6) is fixedly provided on the extensional tooth (42), wherein the auxiliary heat dissipation component (6) comprises a V-tooth or straight-tooth structure, or the auxiliary heat dissipation component (6) is formed by bending the extensional tooth (42).

11. A method for dissipating heat from a device, the method comprising:
absorbing, by a heat dissipation component (4), heat generated by a heat release apparatus (2), wherein the device comprises a housing (1), the heat release apparatus (2), a heat sink substrate (3) and the heat dissipation component (4), wherein the heat release apparatus (2) is arranged inside the housing (1), the heat sink substrate (3) is fixedly connected to the housing (1), the heat dissipation component (4) is fixedly connected to the heat sink substrate (3), and the heat dissipation component (4) covers both a near heat source area and a far heat source area; and
transferring part of the heat from the near heat source area to the far heat source area, so as to enhance heat dissipation by utilizing air in the far heat source area.

12. The method of claim 11, wherein the heat dissipation component (4) comprises a plurality of heat dissipation teeth (40) arranged in parallel to and spaced apart from each other; and each of the heat dissipation teeth (40) comprises a straight tooth (41), an extensional tooth (42), an inner cavity (43), and a heat transfer working medium (44), wherein the extensional tooth (42) and the straight tooth (41) are of an integrated structure, the configuration of the extensional tooth (42) is not limited, the straight tooth (41) is arranged within the range of a substrate outer edge of the heat sink substrate (3), the extensional tooth (42) partially or completely extends beyond the range of the substrate outer edge of the heat sink substrate (3), the straight tooth (41) is located in the near heat source area, the extensional tooth (42) is located in the far heat source area, and the inner cavity (43) is filled with the heat transfer working medium (44).

13. The method of claim 12, wherein transferring of part of the heat from the near heat source area to the far heat source area comprises:
creating a pool boiling state in the inner cavity (43) by the heat transfer working medium (44) absorbing heat, and transferring part of the heat to the far heat source area through vaporization.

14. The method of claim 12, wherein a main evaporation area of the heat dissipation tooth (40) is located in a lower inner cavity in the straight tooth (41), and a main condensation area of the heat dissipation tooth (40) is located in an upper inner cavity in the extensional tooth (42).
